**Europäisches Patentamt**

**European Patent Office**

**Office européen des brevets**

(19)

(11) Publication number: **0 137 992**
**A2**

# EUROPEAN PATENT APPLICATION

(12)

(21) Application number: **84110211.4**

(22) Date of filing: **28.08.84**

(51) Int. Cl.⁴: **H 01 L 29/72**

(30) Priority: **29.09.83 JP 181140/83**
**30.12.83 JP 248242/83**

(43) Date of publication of application: **24.04.85**
**Bulletin 85/17**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Nakano, Motoo, 312-3-9-913, Imaicho Hodogaya-ku, Yokohama-shi Kanagawa, 240 (JP)**

(74) Representative: **Seeger, Wolfgang, Dipl.-Phys., European Patent Attorney Bereiteranger 15, D-8000 München 90 (DE)**

(54) Lateral bipolar transistor formed in a silicon on insulator (SOI) substrate.

(57) A lateral bipolar transistor formed on a silicon on insulator (SOI) substrate, having a base electrode of heat resistive polycrystalline silicon of first conductivity type, formed on a base region of first conductivity type, all the bottom plane of the transistor region is in contact with the insulating layer of the SOI substrate. The base electrode is extended laterally over a part of a collector region to provide a relatively large base electrode width, which allows a small width of the base region, enhancing the current amplification factor of the transistor. The base region has a vertical doping profile which has a minimum value between the base electrode and the insulator layer of the substrate, reducing the recombination of carriers in the base region. Fabricating methods utilizing self-alignment-diffusion process are provided.

<u>TITLE OF THE INVENTION</u>

LATERAL BIPOLAR TRANSISTOR FORMED IN A SILICON ON INSULATOR (SOI) SUBSTRATE

<u>BACKGROUND OF THE INVENTION</u>

The present invention relates to a lateral transistor formed in a silicon on insulator (SOI) substrate and relates to a method for fabricating the lateral transistor. More particularly, it relates to a lateral transistor having a high current amplification factor, low base region series resistance and accurate structural dimension attained utilizing a self-alignment process.

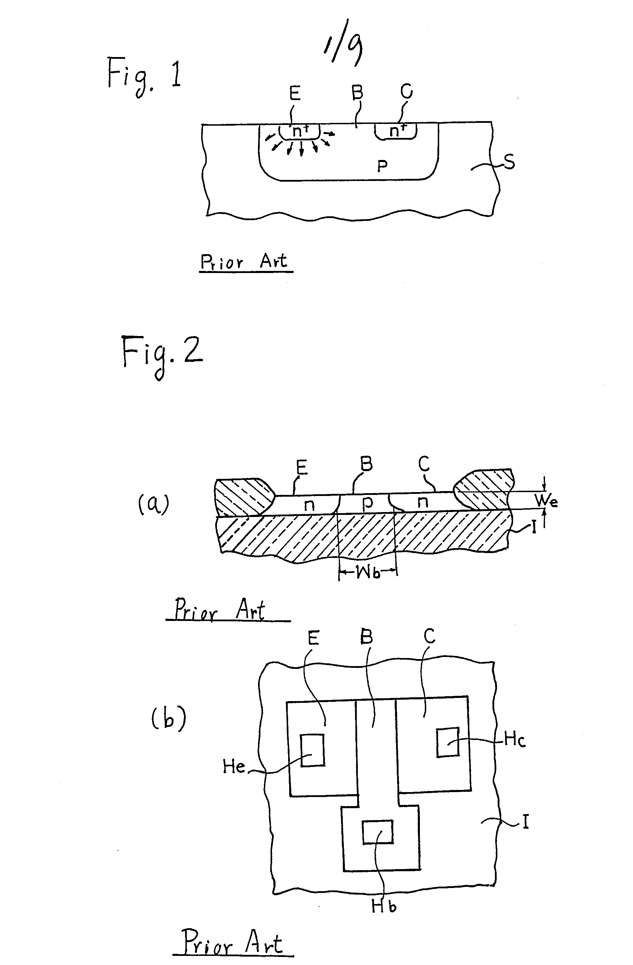

Through all this document, *lateral* means a direction parallel to the surface of a semiconductor substrate, in which the lateral transistor is formed, and *vertical* means a direction perpendicular to the surface of the substrate. A cross-sectional view of a basic structure of a prior art lateral transistor, formed in an integrated circuit (IC) semiconductor device, is illustrated in Fig.1. The structure differs most radically from conventional (vertical) transistors in that the transistor action is performed in a lateral direction rather than vertical direction. A lateral transistor is used advantageously, because of its simple structure, in building a pnp transistor in a npn process, or vice versa, without requiring an additional process. Especially, it is

-2-

widely used for an IC having metal insulator silicon (MIS) field effect transistors (FET) as dominant active elements.

Generally, the lateral transistor has a structure, as shown in Fig.1, wherein an emitter region E and a collector region C of $n^+$ type dopant, for example, are formed separately in a p-type doped base region B formed in a substrate S. Accordingly, the carriers from the emitter region E are transported to all directions in the base region B and most of the carriers fail to reach the collector region C. This means that the transportation efficiency of carriers in the base region is low, resulting in a low current amplification factor of the lateral transistors. In addition, the parasitic capacitances are so high that the switching speed of the lateral transistor are decreased.

In order to remove above disadvantages, a lateral transistor having an improved structure was developed, wherein the base region except the portion positioned between the emitter region and the collector region is removed by etching, or each region is formed on an insulator I or a SOI substrate as shown in Fig.2. In Fig.1 and Fig.2, like reference letters are used for like parts. In the above structure, the carriers injected into the base region are concentrated into a portion between the emitter region E and the collector region C, resulting in an increase in the transportation efficiency of the carriers and the parasitic capacity of each region is decreased. But still remains a problem.

-3-

Generally, the transporting efficiency of the carriers goes up as the lateral width $W_b$ of the base region B (this will be referred as "base width" in the following) becomes smaller. The minimum value of the base width $W_b$ is limited by two factors. The one is the accuracy limit of masks used and the tolerance of the mask alignment for forming the emitter region E and the collector region C leaving the base region B between them. The other is the fundamental structure of the base electrode. For the emitter region E and the collector region C, it is necessary to provide the conventional structure of electrodes with respective contact holes, He or Hc, opened in an insulator layer covering the regions. But such a conventional electrode can not be applicable to the base region B because of its narrow base width. Accordingly, the base region is extended in the longitudinal direction to the outside area, as shown in a plan view of Fig.2 (b), where a conventional base contact hole Hb is formed for the base electrode. In this case, the longitudinal resistance of the base region B is high, causing the actual base-emitter junction voltage along the junction to drop from the externally applied value. This results in decrease in the injection efficiency of carriers from the emitter region E to the base region B causing the characteristics of the transistor to be degraded seriously.

In addition, as shown in a cross-sectional view in Fig.2 (a), the lateral width $W_b$ of the base region is significantly larger than the vertical width $W_e$ of the base region B by almost one to several times. For example, for the vertical $W_e$ of 0.5 to 1.0 μm, the lateral width $W_b$ is formed 2.0 μm. Such a dimension ratio of $W_e$ to $W_b$ causes the recombination of carriers, injected through the emitter-base junction, as will be described later.

These are the problems to be solved.


## SUMMARY OF THE INVENTION

It is an object of the present invention to provide a lateral transistor formed on a SOI substrate with an enhanced current amplification factor.

It is another object of the present invention to provide a bipolar lateral transistor having a base electrode structure to reduce the voltage drop along the emitter-base junction.

It is still another object of the present invention to provide a lateral transistor having a base region, wherein the concentration distribution of dopants contained in the base region has a special profile in the vertical direction to reduce the recombination of carriers passing through the base region.

It is a further object of the present invention to provide a reliable method for fabricating the lateral transistors described above, providing high dimensional accuracy enough to form a significantly small base width.

The foregoing objects are attained by adopting the following structures of the lateral transistor and fabricating method thereof. A base electrode of heat resistive semiconductor material such as highly doped polycrystalline silicon is formed on the surface of a narrow base region of the lateral transistor. The base electrode is heavily doped by the dopants of the same conductivity type as that of the base region, so that the base electrode has a high conductivity, enough to prevent the voltage drop along the narrow base electrode. Accordingly, almost the same voltage as the voltage applied externally to the base terminal is applied to the emitter-base junction, resulting in significant increase in carriers injected into the base region from the emitter region. This is effective to enhance the current amplification factor of the lateral transistor in comparison with a conventional one. Generally, the width of a base region is formed as small such as a few μm. Therefore, the width of the base electrode is forced to be narrower than the base width, and from the fabricating view point, such a fine structure provides a serious problem regarding the dimension accuracy and the pattern alignment.

The first problem, a significantly narrow width of the base electrode, is solved by widening the width of the base electrode towards the collector region side, overlapping the collector region partially. As the material of the base electrode is heat resistive, the substrate can be heated up to a specified temperature for diffusing the dopants, which is implanted inside the base electrode beforehand, rapidly throughout the base electrode. Furthermore, the dopants diffuse into the overlapped portion of the collector region whose dopant concentration is lower than that of the base electrode. The dopants contained in the base electrode is of opposite conductivity type to that in the collector region, a junction is formed between the base electrode and the collector region. Usually the collector region has a double doped region. Namely, the collector region comprises a lightly dosed first collector region and heavily doped second region which has a high conductivity and plays a roll of a collector electrode. As the base electrode overlaps the lightly doped first collector region, the dopants diffuse from the electrode into the collector region, and a junction is formed in the collector region, a monocrystal region. Therefore, the junction has a high breakdown voltage almost the same as that of the base-collector junction. Of course, the widened base electrode should be spaced from the second collector region and the emitter region.

For further enhancement of the current amplification factor of the bipolar lateral transistor according to this invention, the vertical distribution of the dopants inside the base region is provided with a downward concave profile, namely, the dopants concentration comes up toward the boundary (interface) between the base electrode and the base region and the another boundary between the base region and the insulator layer of the SOI substrate. The distribution profile has a minimum point at its almost center portion. The profile of the electric field in the base region in the vertical direction, has almost similar shape as that of the electric charge distribution described above, because the electric field is defined by the dopant distribution. Accordingly, the carriers travelling through the base region are guided to the center portion of the region, reducing the probability of collision of the carriers with recombination centers locating at the boundaries. Such a profile of the dopant concentration distribution is attained by conventional ion implantation by controlling the accelerating energy as will be described later.

The second problem, the dimension accuracy of the various parts of the device, especially the base region width, and the alignment accuracy, especially the alignment of the base electrode to the base region, are solved by the diffusion-self-alignment (DSA) method. For this purpose, a narrow insulator layer,an insulator rail,is useful for the fabricating process. As will be described later in detail, at first the base electrode is formed on a substrate. The insulator rail, such as a silicon dioxide rail, is formed on the side wall of the base electrode. The emitter region and the collector region are formed by a conventional implantation and diffusion technology utilizing the insulator rail as a mask. With this method, a significantly narrow base width such as 1 μm or below can be attained and the alignment of the base electrode to the base region is substantially satisfactory. As a result, the

-8-

bipolar lateral transistor is fabricated with the accuracy of approximately 500 $\overset{\circ}{A}$ for its main structure.

In addition, as the base region is formed by a lateral diffusion process, a dopant concentration from the emitter-base junction to base-collector junction is formed, which provides an electric field prompting the passing carriers in the base region to drift to the collector region, namely "drift effect". This increases the transportation efficiency of the carriers.

Furthermore, the emitter-base and collector-base parasitic capacities become small ultimately, providing the transistor with higher switching speed.

From the point of view of fabricating the highly integrated semiconductor (IC) device, such a bipolar lateral transistor of high current amplification factor is useful to save the space on a substrate by replacing MOS-type elements. The easiness of the fabrication of such a lateral transistor into an IC devices is also a substantial advantage.

The details of the embodiments of the present invention are discussed below together with the accompanying drawings.

BRIEF DESCRIPTION OF DRAWINGS

Fig.1 is a cross-sectional view illustrating schematically the structure of a prior art lateral bipolar transistor formed in a semiconductor substrate.

-9-

Fig.2 (a) is a cross-sectional view of a prior art lateral bipolar transistor formed on a silicon on insulator (SOI) substrate.

Fig.2 (b) is a plan view of a prior art lateral bipolar transistor, illustrating the arrangement of the electrodes.

Fig.3 (a) is a cross-sectional view of a lateral bipolar transistor formed on a SOI substrate according to the present invention illustrating its structure.

Fig.3 (b) is a plan view of the same lateral bipolar transistor as that in Fig. (a).

Fig.4 (a) is a plan view of a lateral bipolar transistor of another type, formed on a SOI substrate, according to the present invention

Fig.4 (b) is a cross-sectional view of the same lateral bipolar transistor as that in Fig.4(a).

Fig.5 (a) illustrates graphically a dopant concentration distribution in the base region of a lateral bipolar transistor formed on a SOI substrate according to the present invention

Fig.5 (b) illustrates graphically the electric field intensity distribution in the base region of a lateral bipolar transistor formed on a SOI substrate according to the present invention corresponding to the dopant distribution shown in Fig.5 (a).

Fig.5 (c) illustrates graphically another dopant concentration distribution in the base region of a lateral bipolar transistor formed on a SOI substrate according to the present invention

Fig.6 (a) to (k) are cross-sectional views of the lateral bipolar transistor shown in Fig.4 (a) and (b) illustrating the structure at respective steps of its fabricating method, the first method.

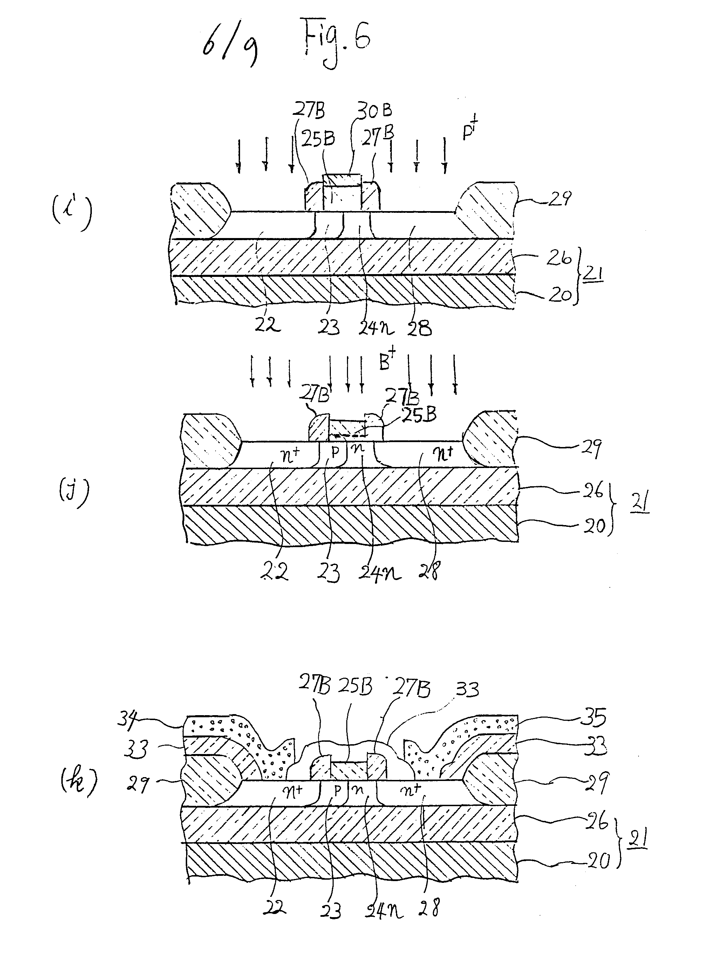

Fig.6 (a) is a cross-sectional view of a SOI substrate for the lateral transistor.

Fig.6 (b) is a cross-sectional view of the lateral bipolar transistor after the phosphorus implantation into the transistor region.

Fig.6 (c) is a cross-sectional view of the lateral bipolar transistor after a polysilicon layer and a silicon nitride layer are formed.

Fig.6 (d) is a cross-sectional view of the lateral bipolar transistor after the base electrode is patterned.

Fig.6 (e) is a cross-sectional view of the lateral bipolar transistor after a silicon dioxide layer is formed covering the entire substrate.

Fig.6 (f) is a cross-sectional view of the lateral bipolar transistor after the insulator rail is formed on the side wall of the base electrode.

Fig.6 (g) is a cross-sectional view of the lateral bipolar transistor after boron implantation is performed for the base region.

Fig.6 (h) is a cross-sectional view of the lateral bipolar transistor after the boron dopants is diffused.

Fig.6 (i) is a cross-sectional view of the lateral bipolar transistor after phosphorus implantation is performed for the emitter region and the first collector region.

Fig.6 (j) is a cross-sectional view of the lateral bipolar transistor after boron implantation is performed into the base electrode.

Fig.6 (k) is a cross-sectional view of the lateral bipolar transistor after finishing the wiring to every electrode contact.

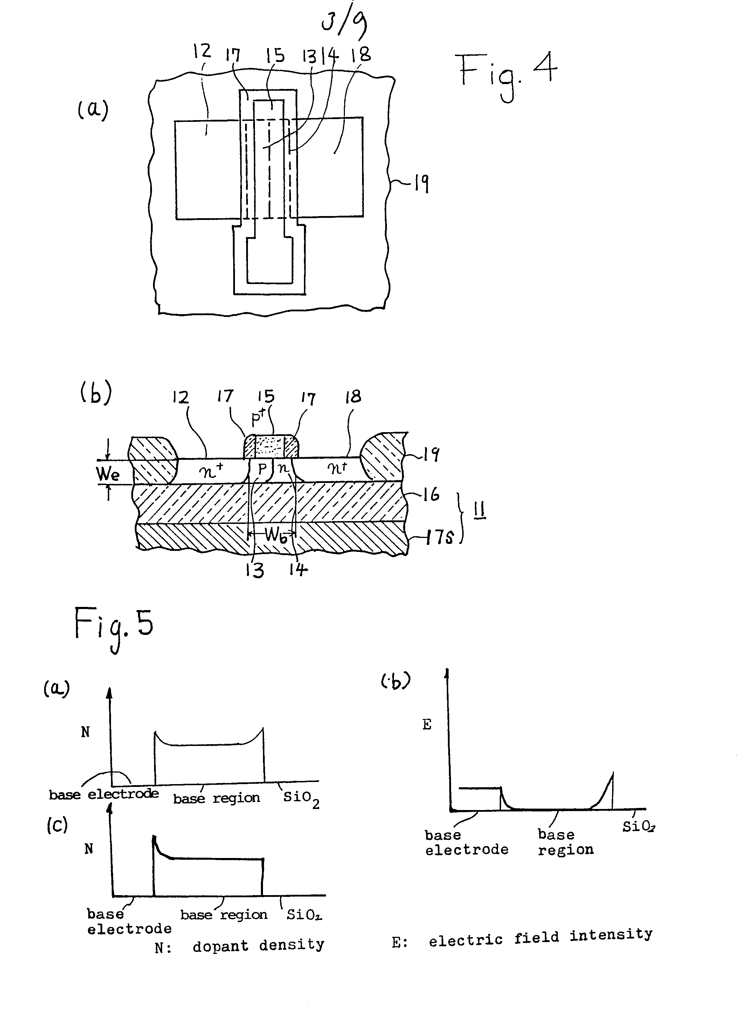

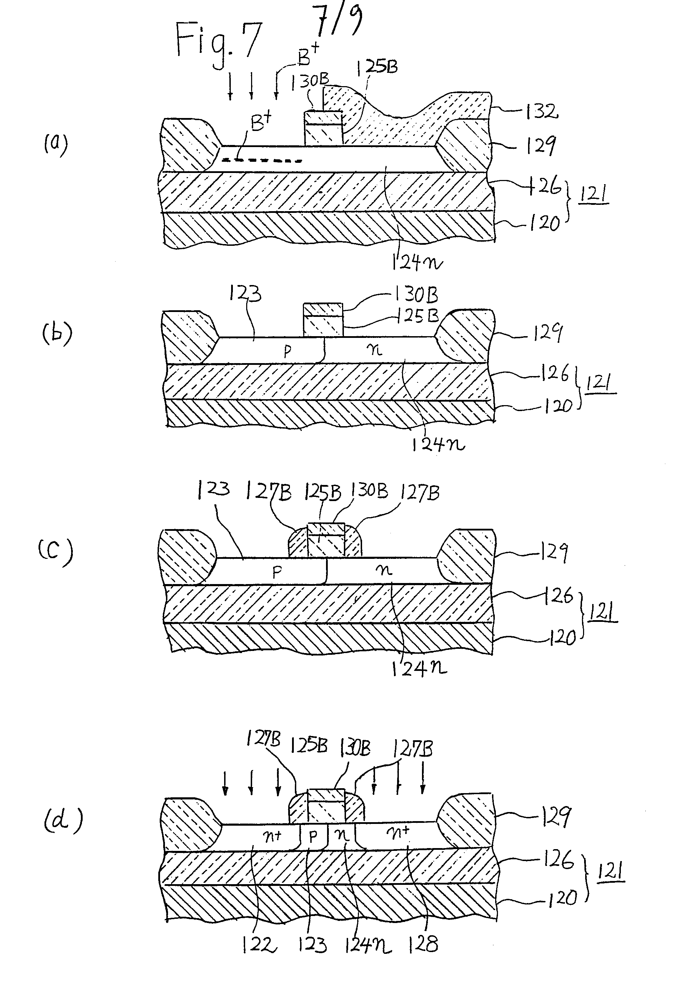

Fig.7 (a) to (d) are cross-sectional views of the lateral bipolar transistor shown in Fig.4 (a) and (b) illustrating the structure at respective steps of its another fabricating method, the second method.

Fig.7 (a) is a cross-sectional view of the lateral bipolar transistor after a boron implantation is performed for base region.

Fig.7 (b) is a cross-sectional view of the lateral bipolar transistor after the implanted boron dopants are diffused to form a diffusion region.

Fig.7 (c) is a cross-sectional view of the lateral bipolar transistor after an silicon dioxide rail is formed on the side wall of the base electrode.

Fig.7 (d) is a cross-sectional view of the lateral bipolar transistor after phosphorus implantation and a diffusion process to form an emitter region and a collector region.

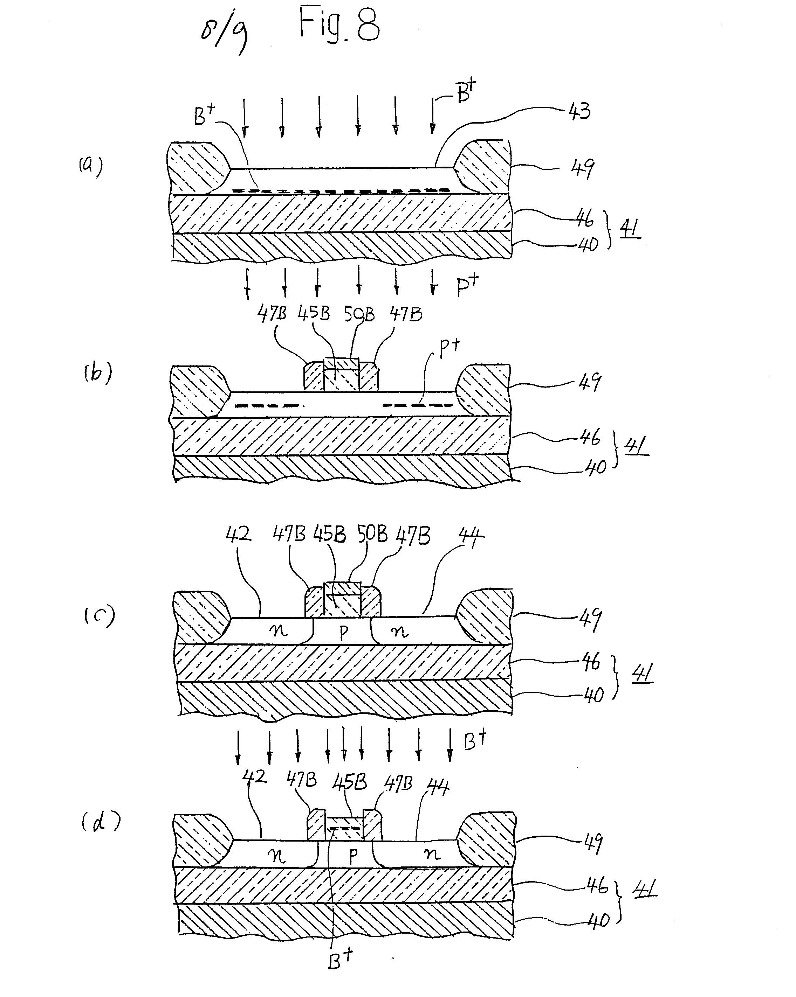

Fig.8 (a) to (d) are cross-sectional views of a lateral bipolar transistor having a concave doping profile within the base region in the vertical direction illustrating the structure at the respective steps of fabricating process by the third method.

Fig.8 (a) is a cross-sectional view of the lateral bipolar transistor after boron implantation to form a heavily concentrated dopant distribution at the bottom of the base region.

Fig.8 (b) is a cross-sectional view of the lateral bipolar transistor after a base electrode, protected atop by a silicon nitride layer, and a silicon dioxide rail on the side wall of the base electrode are formed.

Fig.8 (c) is a cross-sectional view of the lateral bipolar transistor after phosphorus implantation and subsequent diffusion process to form an emitter region and a collector region.

Fig.8 (d) is a cross-sectional view of the lateral bipolar transistor after boron implantation for doping the polysilicon layer of the base electrode.

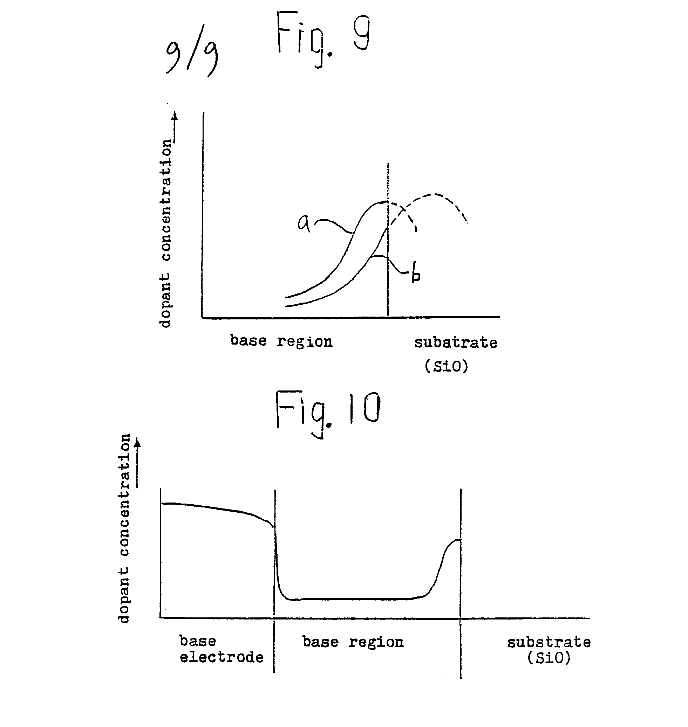

Fig.9 illustrates graphically a doping profile of the diffused boron dopants in the base region and the adjacent silicon dioxide layer of the SOI substrate, after the fabricating step shown in Fig.8 (a).

Fig.10 illustrates graphically a doping profile of the diffused boron dopants in the base region and the adjacent silicon dioxide layer of the SOI substrate, after the fabricating step shown in Fig.8 (d): (the final doping profile)

DETAILED DESCRIPTION OF PREFERRED EMBODIMENTS

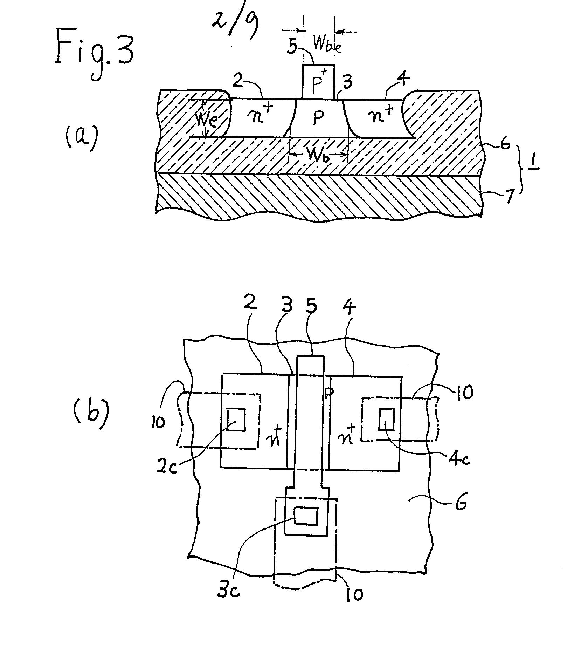

Fig.3 (a) and (b) are respectively a magnified cross-sectional view and a plan view of an embodiment of lateral bipolar transistor formed in a SOI substrate 1 according to the present invention. A base electrode 5 of polycrystalline silicon (hereafter will be referred as "polysilicon") is formed on a narrow base region 3, extending to the outside area of the transistor, where a base contact 3c is positioned, as shown in Fig. 3(b). In this case, the lateral transistor is of npn type. The base region 3 is a p-type doped region, doped with boron (B) of $10^{17}$ atm/cm$^3$ concentration, for example, and an emitter region 2 and collector region 4, are both n-type regions doped with phosphorus (P) of $10^{20}$ atm/cm$^3$ concentration, and positioned on the both sides of the base region 3. The emitter region 2, the base region 3 and the collector region 4 are built in a silicon dioxide ($SiO_2$) layer 6 and share each boundary with the silicon dioxide layer 6. The emitter region 2, the base region 3 and the collector region 4 are also connected to conductive paths 10 (shown with dot-dash lines) through respective contact holes 2c, 3c and 4c opened in an insulator layer (not shown) covering the surface. The reference numeral 7 denotes a monocrystal layer on which the silicon dioxide layer 6 is formed. The base electrode 5 is heavily doped with boron (B) of $10^{19}$ atm/cm$^3$ concentration, which provides the electrode with a sufficient conductivity so that the voltage drop along the electrode 5 may be neglected. As a result, a significant carrier injection occurs through the emitter-base junction into the base region 3, and the degradation of the characteristics of the lateral transistor is prevented satisfactorily.

In order to increase the current amplification factor of a lateral transistor, it is very important to reduce the base width $W_b$ as small as possible. But in the above embodiments, the base width must be wider than the width of the base electrode $W_{be}$, which is limited by the fabricating technology. Generally, the width of the base electrode 5 is limited by a photo-lithographic technology, and it is very difficult to make it narrower than 2 μm because of the accuracy limitation of the mask used and the tolerance of the alignment of the mask. On the other hand, the vertical depth $W_e$ is much smaller than $W_b$ such as 0.4 to 0.5 μm. Accordingly, the carriers, are apt to recombine during their transportation through the base region 3, and the current amplification factor is degraded.

A lateral transistors having a further improved structure, an embodiment of the present invention, is illustrated in a plan of view of Fig.4 (a) and in a cross-sectional view of Fig.4 (b). This improved structure, in short, allows a wider base electrode than that of the lateral transistor on a SOI substrate shown in Fig.3. On a silicon dioxide ($SiO_2$) layer 16 formed on a monocrystal silicon layer 17s of a SOI substrate 11, an emitter region 12, base region 13 and a collector region comprising two regions, namely, a first collector region 14 and second collector region 18, are formed and each of the regions are positioned in the recited order and joins the other to form a transistor region. The emitter region 12 and the second collector region 18 are most heavily doped with phosphorus (P) at $10^{20}$ atm/cm$^3$ concentration forming n-type regions. The first collector region 14 contains phosphorus (P) dopants of $10^{16}$ atm/cm$^3$, the lightest dopant concentration. The base region 13 and the base electrode 15 are p-type regions, doped with boron (B) of $10^{17}$ atm/cm$^3$ and $10^{19}$ atm/cm$^3$ concentration respectively. The edges of the emitter to base boundary and the base to second collector boundary should be apart from the base electrode 15, otherwise electrical shortage or breakdown of the boundary will occur between the base electrode 15 and emitter region 12 or second collector region 18. This is because the dopants of higher concentration in the base region 12 or second collector region 18 intrude into the base electrode 15 of lower dopant concentration and form a junction in the base electrode 15 of polysilicon. The breakdown voltage of newly formed junction is significantly low due to the complicated polycrystalline structure.

- 16 -

On the other hand, with the structure of Fig.4, between the base electrode 15 and the first collector region 14, a junction is formed in the first collector region 14 whose structure is a monocrystal, because the dopant concentration in the base electrode 15 is significantly higher than that of the first collector region 14. A junction formed in a monocrystal layer is usually strong and has a high breakdown voltage. This is the reason why the base electrode 15 can extend over the base region 13 laterally and cover a part of the first collector region 14. In addition, the lesser dopant concentration of the first collector 14 enhances the base to collector breakdown voltage of the transistor. From this point of view, in addition to polysilicon, silicides of refractory metal, such as molybdenum silicide ($MoSi_2$), tungsten silicide ($WSi_2$), etc are available.

The width of the first collector 14 is determined considering the width of the base electrode 15 and the spacing between the base electrode 15 and the second collector region 18. The actual dimensions in this example are as follows. The base width is 1 to 2 μm, the width of the first collector region 14 is 1 to 2 μm, the width of the base electrode 15 is approximately 2 μm and the vertical depth of the transistor region is 0.4 to 0.5 μm. The layers denoted by reference numeral 17 are silicon dioxide ($CO_2$) layers formed on the side walls of the base electrode 15. These layers 17 are used for diffusion-self-alignment (DSA) method for patterning of the transistor, providing the lateral transistor with a higher dimensional accuracy and easier process as discussed later.

Accordingly, there are two featured advantages for the fabrication of the transistor. The one is that the base width $W_b$ is controlled easily by adjusting the diffusion process for forming the emitter region 12 resulting in a narrow base width $W_b$ below 1 μm. The another advantage is that the width of the base electrode can exceed the base width, in another words, the base width is less limited by the width of the base electrode 15 than the former transistor shown in Fig.3. The fabricating method for a lateral transistor with this structure will be described in detail later.

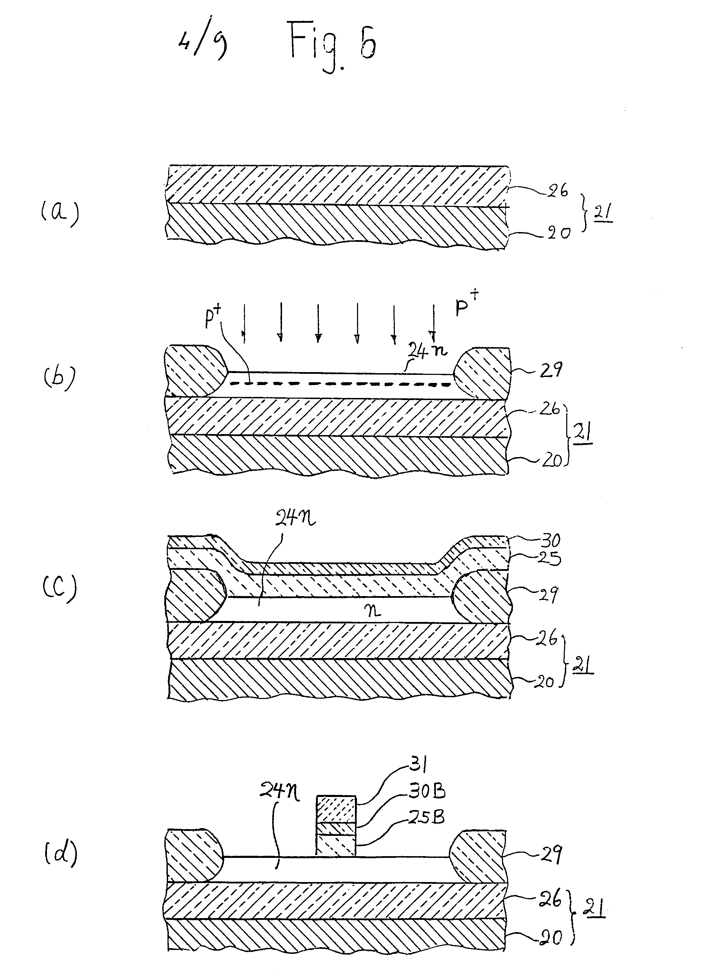

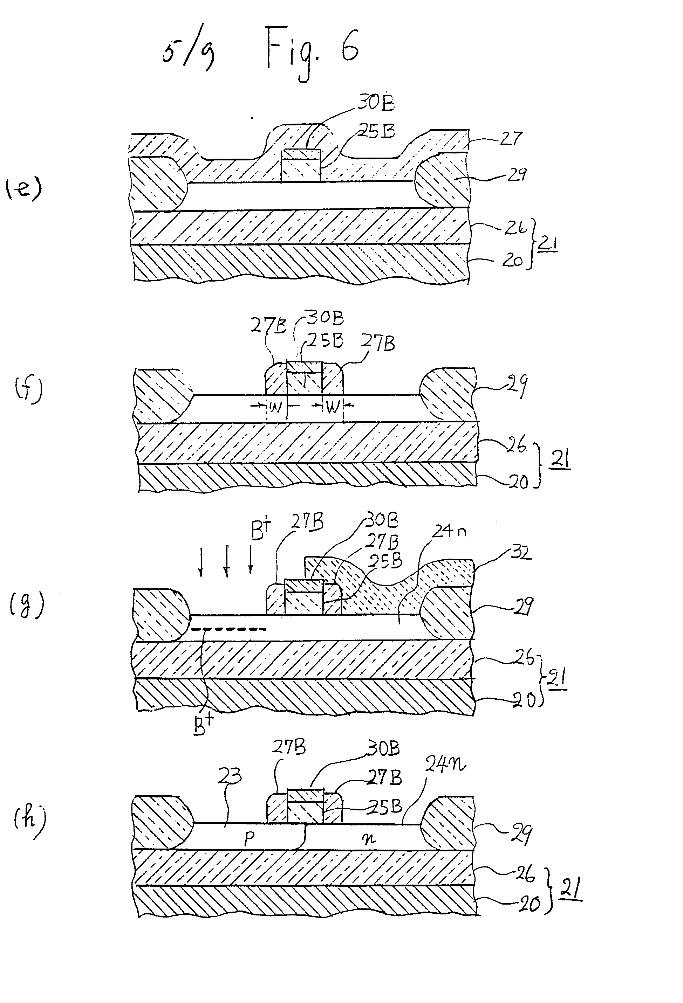

Before description of a further improvement of transportation efficiency of carriers in a base region, the recombination of the carriers will be discussed briefly. As already pointed out in the above description, the vertical width $W_e$ of the base region is usually narrower than the lateral width $W_b$. This results in collision of the carriers with recombination centers positioning on the boundary walls parallel to the direction of the flow of the carriers: the base electrode-base region boundary wall (will be referred as upper wall) and the base region-insulator boundary region (will be referred lower wall). In order to reduce the collision of carriers with the recombination centers existing on the walls, the movement of the carriers can be controlled to guide them to the center portion between the upper wall and lower wall by forming a suitable electric field inside the base region. This is attained by controlling the distribution of the dopants contained in the base region, because the electric field inside the region is defined by dopants. The dopant distribution in a base region of an improved embodiment is illustrated in Fig.5 (a), wherein the distance between the base electrode and the insulator ($SiO_2$) is on the abcissa, and the dopant (boron) concentration is on the ordinates. As seen in the figure, the impurity distribution has a downward concave curve and the impurity distribution is higher in the regions near the both walls. As a result, almost the same pattern of the electric field strength is attained as shown in Fig.5 (b). The electric field of such a profile guides the carriers (in this case, minus charged carriers, electrons) toward the center portion between the walls and prevent from colliding with the recombination centers distributed at the walls. Generally, the distribution of the recombination center on the base region-insulator layer boundary, lower wall, can be made small, whereby the higher concentration of dopants near the lower wall is not always necessary, and can be omitted. Accordingly, the pattern of the dopants distribution shown in Fig.5 (c) is also effective in practice. A lateral transistor having a base region with such a dopant distribution will have an enhanced current transconductance. A method for obtaining the above lateral transistor will be described later.

For a lateral transistor having a base region with uniformly distributed dopants, the same effect can be attained by applying a bias voltage to the substrate, that is, a minus bias voltage for minus charged carriers, electrons, and a plus bias voltage for plus carriers, holes.

Now a method for fabricating a lateral transistor shown in Fig.4 will be discussed referring to drawings Fig.6 (a) to (k), corresponding to each fabricating step. The method described herein will be referred as the first method. At first, a SOI substrate 21 illustrated in Fig.6 (a) is prepared. The SOI substrate comprises an insulating layer of silicon dioxide ($SiO_2$) 26 formed on a silicon substrate 20. A silicon monocrystal layer 24 of 0.5 to 1.0 μm thick is formed on the insulating layer 21. There are several methods for fabricating the SOI substrate, but the description regarding the methods is omitted because it is not the focus of the present invention and some of them are available in the market. A silicon on sapphire (SOS) substrate is also applicable.

By a conventional LOCOS (local oxidation of silicon) method, a field oxide region 29 of silicon dioxide ($SiO_2$) is formed in the silicon monocrystal layer 24 defining a transistor region 24n where a transistors is to be formed. The field oxide region 29 joins the insulator layer 26. (In other words, the transistor region is formed by removing the silicon single-crystal layer 26, except the transistor region 24n, by a conventional etching method, providing an air isolation structure). The transistor region 24n is doped by implanting phosphorus (P) with a dose of $10^{13}/cm^2$ at 80 to 100 Kev as shown in Fig.6 (b). In the figure, the lateral thick dotted line illustrates a layer of concentrated dopants implanted. This dotted line illustrates a similar implanted dopants layer in the following figures. The substrate 21 is heated in a furnace at 1050 to 1100$^O$C for 30 to 60 minutes to diffuse the dopants to form a lightly doped n-type diffusion region 24n of $10^{16}$ atm/cm$^3$ concentration. This process is followed by a conventional chemical vapor deposition (CVD) method, by which a non-doped polysilicon layer 25 of 0.4 to 0.5 μm thick is formed covering all the surface of the substrate 21. A silicon nitride ($Si_3N_4$) layer 30 of 0.2μm thick is formed by the similar CVD method over the polysilicon layer 25, as shown in Fig.6 (c).

Next, the silicon nitride layer 30 is covered by a photoresist film 31, and is patterned by a conventional photo-lithographic technology to form a photoresist mask, then, by a conventional reactive ion etching (RIE) method, a polysilicon layer 25 and silicon·nitride layer 30 are etched off to form a base electrode 25B having a silicon nitride layer 30B on it, as shown in Fig. 6 (d). In the above RIE method, as an etching gas, carbontetrafluoride ($CF_4$) gas is used for silicon nitride layer and carbontetrachloride ($CCl_4$) gas for polysilicon layer.

After removing the photoresist layer 31 on the top of the base electrode 25B, a silicon dioxide layer 27 of 0.6 to 1.0 μm thickness is formed covering the surface of the substrate as shown in Fig.6 (e).

Employing an powerful anisotropic etching method, namely, a directional RIE method, the silicon dioxide layer 27 is removed, as shown in Fig.6 (f), leaving a rail insulator 27B on the side walls of the base electrode 25B of approximately the same width W as the thickness of the silicon oxide layer 27, that is, 0.6 to 1.0 μm. The etchant used here is carbontetrafluoride ($CF_4$) or trifluoromethane ($CHF_3$).

Covering the partial area of the transistor region 24n located on the one side of the base electrode 25B with a photoresist layer 32, the exposed area of the transistor region 24n, n-type doped silicon single-crystal layer, is implanted with boron (B) ions, with a dose of $3 \times 10^{14}$ atm/$cm^2$ at 30 Kev, for example as shown in Fig.6 (g). Clearly, the ion implantation is performed utilizing the base electrode 25B and the insulator rail 27B as a mask, and the edge of the insulator rail 27B plays a roll of a pattern edge. This is a self-alignment method.

Following the implantation, the photoresist layer 32 is removed and the dopants concentrating in the transistor region 24n, or a lightly doped silicon layer, are diffused by heating the substrate at 1050 °C, for instance, for a specified time in a furnace to form a p-type diffusion region 23 with boron (B)

-22-

dopants of approximately $10^{17}$ atm/cm$^3$ deity. The diffusion of the dopants is controlled exactly so that the diffusion region 23 formed reaches the underlying insulator 26 completely to share a boundary with it and the edge of the boundary (p-n junction) formed, between the emitter region 23 and the remained silicon layer 24n, reaches laterally underneath the base electrode 25B as shown in Fig.6 (h). The location of the boundary is predetermined depending on the required current amplification factor and junction breakdown voltage. The above lateral diffusion of the B dopants is controlled to a specified length such as 2.0 μm from the edge of the silicon dioxide rail 27B. The p-type diffusion region 23 close to the boundary has a declined distribution of the dopants concentration.

Again heavy ion-implantation of phosphorus (P) ions is performed on to the substrate with a dose of $5 \times 10^{15}$ atm/cm$^2$ at 60 Kev, for instance. The exposed n-type doped silicon region 24n and p type doped silicon region 23 are ion-implanted and the base electrode 25B is not implanted by the protection of the silicon nitride layer 30B. This step is followed by a diffusion step, wherein the substrate is heated at 950 to 1000 °C, for instance, for a specified time, so that the exposed area of the p-type diffusion region 23 is doped heavily to turn to a n-type diffusion region, an emitter region 22, leaving a narrow diffusion region, a base region 23 as shown in Fig.6 (i). The diffusion process is carefully controlled so that the width of the base region 23, the base width $W_b$, is accurately obtained.

On the other hand, the exposed area of the remained lightly doped region 24n turns to a heavily doped n-type region 28, leaving a part of lightly doped n-type region 24n. Both n-type regions 24n and 28 compose a collector region. The lightly doped n-type region 24n is a collector region with a necessary breakdown voltage. As seen in the figure, the diffused regions 22 and 28 should diffuse vertically to reach the surface of the insulator layer 26 perfectly and also diffuse laterally until the edge of the boundary between the region 22 and the region 23 and the boundary between the region 24n and 28 come to the underneath the insulator rails 27B respectively and both boundaries should not reach the base electrode 25B. The lateral diffusion of the dopants is controlled so that the boundary of the diffusion region 22 intrudes from the edge of the insulator rail 27B, a pattern edge, by 0.5 μm, providing the base region the width $W_b$ of 1.5 μm.

Now the base electrode 25B of polysilicon is doped. The doping should be performed so that the base electrode 25B has a specified conductivity and also higher dopant concentration than that of the region 24n of an opposite type of conductivity, which share with a junction. This prevents the electrical shortage between the base electrode 25B and the lightly doped first collector region 24n, as the junction is formed inside the region 24n of monocrystal silicon, as stated before. Before doping, the silicon nitride layer 30 is removed chemically with phosphoric acid ($H_3PO_4$) and again a p-type

dopant such as boron (B) ions are implanted over the substrate with a dose of $8 \times 10^{14}$ atm/cm$^2$ at 30 Kev, for instance as shown in Fig.6 (j). The dose is low enough to provide little influence to the conductivity of dopants contained in the region 22 and 28. The boron (B) dopants implanted into the base electrode 25B of polysilicon are diffused by the subsequent diffusion process wherein the base electrode turns to a p-type diffusion region of $10^{19}$ atm/cm$^3$ concentration. In this diffusion process for the base electrode 25B, the rearrangement of dopants inside the monocrystal silicon, namely, in the regions 24n, 23, 22 and 28 does not occur, because the diffusion coefficient of a dopant in a polysilicon is generally significantly higher than that in the monocrystal silicon.

Finally, by a conventional fabricating method, insulator layer 33, a conductive path 34 for the emitter region 22, and a conductive path 35 for the collector 28 (and 24n) are formed to finish a lateral bipolar transistor as shown in Fig.6 (k).

Now, another fabricating method, the second method, a modified first method, will be disclosed referring to Fig.7 (a) to (d). In the following discussion, otherwise mentioned, the fabricating conditions such as an ion implantation accelerating voltage, dose concentration, diffusion temperature, etc, are the same as those of the first method. The reference numerals used in this discussion is defined by adding 100 to that of corresponding numerals used in the preceding discussion.

In the second method, the different point from the first method is that a base region is formed first, utilizing a base electrode itself already formed as a mask, and after that, a silicon dioxide rail along the side wall of the base electrode is formed by a CVD method, and an emitter region is built in the base region. For the sake of simplicity , the modified fabricating steps only will be described. After removing the photoresist layer 31 as shown in Fig.6 (d), the one half portion with regard to the base electrode 125B of the n-type doped region 124n, where the collector region is to be made later, is covered selectively by a photoresist layer 132. This step is followed by a boron (B) implantation as shown in Fig.7 (a). At this implantation step, the base electrode 125B covered by a silicon nitride layer 130B acts as a mask. A p-type region 123 is formed at the subsequent step of thermal diffusion process, wherein the p-type region reaches to the insulator layer 126 and the junction moves laterally towards the n-type doped region 124n and reaches underneath the base electrode 125B as shown in Fig.7(b). In the same steps as those of foregoing embodiments shown in Fig.6 (e) and (f), a silicon dioxide rail 127B is formed by a CVD method as illustrated in Fig.7(c), which is the same as that shown in Fig.6(h). The subsequent steps are the same as those of the foregoing embodiment.

Still another embodiment having a special dopant distribution in its base region, as suggested above, will be discussed. In the foregoing embodiments, the base regions are

-26-

defined by the lateral diffusion of the emitter region or the collector region through a previously formed doped monocrystal silicon region. In this method, each region is defined by lateral diffusion of respective dopants, and the dopant concentration varies in the direction vertical to the surface of the substrate. The method is described in the following referring to Fig.8. The description of the same fabricating steps of the third method as those of the first method are omitted for the sake of simplicity.

On a SOI substrate 41 comprising monocrystal silicon layer 43 formed on an insulator ($SiO_2$) layer 40, a transistor region is defined by forming a field oxide region 49 as shown in Fig.8(a). The transistor region is doped uniformly with boron (B) with a dose concentration of $10^{17}$ atm/cm$^3$ to form a p-type region. In order to provide the silicon region 43 with a predetermined dopant distribution, deep boron implantation is performed with a dose of $4 \times 10^{13}$ atm/cm$^2$ at 200 KeV to obtain a projection range (Rp) of 5000 Å. By this deep implantation, the boron concentration in the silicon layer 43 at the boundary to the underlying $SiO_2$ insulator layer 46 comes up to $10^{19}$ atm/cm$^3$. Subsequent diffusion process is performed at 850 to 900 °C, resulting in a boron dopants concentration distribution in the vertical direction as shown graphically by a curve (a) in Fig.9. By increasing the accelerating energy for ion implantation, the concentration is shifted inwards (downward in the figure) as shown by a curve (b). By adjusting the

-26-

-27-

accelerating energy for ion implantation, the profile of dopant concentration in the base region can be changed. Following the same fabricating steps for the first method shown in Fig.6 (c) to (f), a polysilicon base electrode 45B is formed across the transistor region 43 as shown in Fig.8(b). The top of the electrode 45B is protected by a silicon nitride ($Si_3n_4$) layer 50B and the side wall of the base electrode 43 is covered by a silicon dioxide ($SiO_2$) rail (narrow layer) 47B. The monocrystal silicon layer 43 remains as a boron doped region with a concentration distribution shown in Fig.9.

Then follows a phosphorus implantation with a high dose of $5 \times 10^{15}$ atm/$cm^2$ at 180 KeV, (Rp=2300 $\overset{o}{A}$) to form an emitter region 42 and a collector region 44 at the exposed monocrystal silicon layer 43. In this case, the base electrode 45B and insulator rail 47B act as a mask, and the edge of the insulator rail 47B act as a pattern edge. The silicon nitride layer 50B protects the polysilicon base electrode from phosphorus implantation. The implanted phosphorus dopants are diffused at 850 to 900 $^o$C to.form the base region 42 and the collector region 45 as shown in Fig.8 (c).. The remained monocrystal silicon layer 43 turns to a base region 43, whose base width can be controlled by the diffusion process. Now the silicon nitride layer 50B is removed by a conventional method, and again boron implantation is performed onto the exposed base electrode 45B with a dose of $1 \times 10^{15}$ atm/$cm^2$ at 40 KeV (Rp=1300$\overset{o}{A}$). Naturally boron ions are implanted into the emitter region 42 and the collector region 44, but their conductivity type is not changed because of their dominant n-type dopant (phosphorus) concentration. The base electrode is 4000 to 5000 $\overset{o}{A}$ thick, so the implanted boron dopants reach approximately to the center portion of the electrode 45B between its top surface and the boundary surface to the underlying monocrystal silicon region 43. Generally, the diffusion coefficient of dopants in a polysilicon layer is by approximately one order larger than that in monocrystal layer. Therefore, in the subsequent diffusion process performed at relatively low temperature, such as 900 °C, the implanted boron dopants in the base electrode 45B diffuse through the electrode 45B easily, but they diffuse slowly into the monocrystal region 43. As a result, the concentration of boron dopants in the base electrode 45B comes up to $10^{19}$ atm/cm$^3$ and distributes almost uniformly in the vertical direction, but inside the monocrystal base region 43, the concentration declines rapidly as demonstrated by a curve in Fig.10. In addition, the concentration distribution of dopants already diffused, would change slightly. The dopant concentration distribution in the vertical direction inside the base electrode 45B and base region 43 is illustrated in Fig.10. Thus a concave dopant distribution in the vertical direction inside the base region is obtained. The electric field inside the base region 43 is defined in an almost similar profile to that of the dopant concentration, which guides carriers travelling through the base region 43 to its center portion, to prevent the carriers from collision with recombination centers along the walls of the region 43.

It is possible under some conditions to reduce the concentration of recombination centers along a silicon-silicon dioxide boundary wall. In such a case, the boron implantation into the monocrystal silicon layer 43 shown in Fig.8 (a) can be omitted. This contributes significantly to cut the number of the fabricating steps.

Throughout all the embodiments described above, a lateral transistor of npn type is discussed, but it is apparent that the present invention is applicable to a lateral transistor of inverse type, pnp type. Such application or modification are all in the scope of the present invention.

0137992

-30-
## CLAIMS

1.    A lateral bipolar transistor formed in a silicon layer (16) on an insulator (SOI) substrate comprising:

a base region (13) of a first conductivity type formed in said silicon layer ;

an emitter region (12) of a second conductivity type which is opposite to said first conductivity type, said emitter region being formed in said silicon layer and sharing a junction with said base region;

a collector region (14) of said second conductivity type, formed in said silicon layer, and being positioned at the opposite side of said base region to said emitter region, said collector region sharing a junction with said base region; and

an base electrode of a semiconductor of said first conductivity type formed on said base region, said base electrode sharing an boundary with said base region, being insulated electrically from said emitter region and collector region,

said base region, said emitter region and said collector region being in surface-to-surface contact with said underlying insulator of said substrate.

2.    A lateral bipolar transistor of claim 1, wherein, in the direction vertical to the surface of said substrate, the concentration distribution of dopants of said first conductivity type contained in said base region has a concave

0137992

-31-

profile with a minimum value at a portion between said base electrode and said insulator.

3. A bipolar lateral transistor of claim 1, wherein, in the direction vertical to the surface of said substrate, the concentration distribution of said dopants of the first conductivity contained in said base region has a monotonously declining profile with a minimum value at the boundary between said base region and said insulator.

4. A bipolar lateral transistor of claim 1, 2 or 3, wherein said collector region includes a first collector region (14) and a second collector region (18), said first collector region is more lightly doped than said second region, said first collector region contacts said base electrode (15), and the concentration of the dopants contained in said base electrode is higher than the concentration of the dopants contained in said base region and said first collector region.

5. A bipolar lateral transistor of claim 1, 2, 3 or 4, wherein the width of said base electrode (15) is equal to or wider than the width of said base region (13).

6. A bipolar lateral transistor of claim 1, 2, 3 or 4, wherein said base electrode (15) is of heat resistive semiconductor material.

-31-

-32-

7.    A bipolar lateral transistor  of claim 6, wherein   the material  of  said   base   electrode  is  selected  from  polycrystalline  silicon,  molybdenum  silicide and  tungsten  silicide.

8.       A bipolar lateral transistor of claim  1, 2,  3 or 4, wherein  the side wall of  said base electrode is covered by  a narrow layer (17) (a rail) of insulator having a specified width.

9.    A method for  fabricating a  bipolar lateral transistor, comprising the steps of:

   forming  a field  oxide  layer  to define  a  transistor region of monocrystal silicon on  said insulator formed on said substrate;

   doping lightly  said transistor  region  uniformly  with dopants of first conductivity type;

   forming  a polycrystalline silicon  layer  covering  the entire surface of the substrate;

   forming  a  silicon  nitride  $(Si_3n_4)$  layer  over  said polycrystalline silicon layer;

   forming a narrow base electrode  across  said transistor region, utilizing a patterning method;

   forming an insulating layer covering the  entire surface of the substrate;

removing said insulating layer by an anisotropic etching method leaving an insulator rail covering the side wall of said base electrode;

implanting selectively dopants of first conductivity type into a portion of said monocrystal silicon region of first conductivity type with a light dose, positioning at the one side of said base electrode, utilizing said insulator rail and said remained silicon nitride layer atop said base electrode as a mask;

diffusing said implanted dopants to form a diffusion region of first conductivity, said diffusion region vertically reaching said insulating layer of said substrate at the entire bottom plane and laterally extending to a plane positioning underneath said base electrode;

implanting dopants of second conductivity type with a high dose into said diffusion region of first conductivity type and a portion of said monocrystal silicon region of second conductivity type, said portion positioning at the another side of said base electrode, utilizing said insulator rail and remained said silicon nitride layer atop said base electrode as a mask;

diffusing said dopants implanted at the preceding step to form diffusion regions of second conductivity type whose bottom plane reaching said insulating layer of said substrate, whose side walls reaching predetermined positions underneath said insulator rail;

removing said silicon nitride layer atop said base electrode to expose said polycrystalline silicon layer;

implanting dopants of first conductivity type with a high dose into said polycrystalline silicon layer of said base electrode; and

diffusing said dopants implanted into said base electrode to form a diffusion region reaching the boundary to underlying said diffusion region of first conductivity type and said diffusion region of second conductivity type, said diffusion layer in said base electrode forming a junction with said underlying diffusion region of second conductivity type.

10. A method for fabricating a bipolar lateral transistor, comprising the steps of:

forming a field oxide layer to define a transistor region of monocrystal silicon on said insulator layer formed on said substrate;

doping lightly said transistor region uniformly with dopants of second conductivity type;

forming a polycrystalline silicon layer covering the entire surface of the substrate;

forming a silicon nitride ($Si_3n_4$) layer over said polycrystalline silicon layer;

forming a narrow base electrode across said transistor region, utilizing a patterning method;

implanting selectively dopants of first conductivity type with a light dose into a portion of said monocrystal silicon region of second conductivity type, positioning at the one side of said base electrode, utilizing said base electrode and remained said silicon nitride layer atop said base electrode as a mask;

diffusing said implanted dopants to form a diffusion region of first conductivity, said diffusion region vertically reaching said insulating layer of said substrate and laterally extending to a plane positioning underneath said base electrode;

forming an insulating layer covering the entire surface of said substrate;

removing said insulating layer by an anisotropic etching method leaving a insulator rail covering the side wall of said base electrode;

implanting dopants of second conductivity type with a high dose into said diffusion region of first conductivity type and a portion of said monocrystal silicon region of second conductivity type, said portion positioning at the another side of said base electrode, utilizing said insulator rail and remained said silicon nitride layer atop said base electrode as a mask;

diffusing said dopants implanted at the preceding step to form diffusion regions of second conductivity type whose bottom planes reaching said insulating layer of said substrate, whose side walls reaching predetermined positions underneath said insulator rail;

removing said silicon nitride layer atop said base electrode to expose said polycrystalline silicon layer;

implanting dopants of first conductivity type with a high dose into said polycrystalline silicon layer of said base electrode; and

diffusing said dopants implanted into said base electrode to form a diffusion region reaching the boundary to underlying said diffusion region of first conductivity type and said diffusion region of second conductivity type, said diffusion layer in said base electrode forming a junction with said underlying diffusion region of second conductivity type.

11. A method for fabricating a bipolar lateral transistor, comprising the steps of:

forming a transistor region of monocrystal silicon of first conductivity type on a insulator layer formed on a substrate;

forming a polycrystalline silicon layer covering the entire surface of the substrate;

forming a silicon nitride ($Si_3n_4$) layer over said polycrystalline silicon layer;

forming a base electrode utilizing a conventional patterning method;

forming a insulating layer covering the entire surface of the substrate;

removing said insulating layer by an anisotropic etching method leaving a insulator rail covering the side wall of said base electrode;

doping selected portion of said monocrystal silicon region of first conductivity type with dopants of second conductivity type, utilizing said insulator rail and remained said silicon nitride layer atop said base electrode as a mask;

diffusing said implanted dopants to form the emitter region and collector region;

removing said silicon nitride layer atop said base electrode to expose said polycrystalline silicon layer;

implanting dopants of first conductivity type into said polycrystalline silicon layer of said base electrode; and

diffusing said dopants implanted into said polycrystalline silicon layer to reach the boundary plane to said insulating layer of said substrate.

12. A method for fabricating a bipolar lateral transistor, comprising the steps of:

forming a transistor region of monocrystal silicon of first conductivity type on a insulator layer formed on a substrate;

implanting dopants of first conductivity type with a high dose into said transistor region so as to concentrate

highly at a portion nearby said boundary between said transistor region and said insulator layer;

forming a polycrystalline silicon layer covering the entire surface of the substrate;

forming a silicon nitride ($Si_3N_4$) layer over said polycrystalline silicon layer;

forming a base electrode utilizing a conventional patterning method;

forming a insulating layer covering the entire surface of the substrate;

removing said insulating layer by an anisotropic etching method leaving a insulator rail covering the side wall of said base electrode;

doping selected portion of said monocrystal silicon region of first conductivity type with dopants of second conductivity type, utilizing said insulator rail and remained said silicon nitride layer atop said base electrode as a mask;

diffusing said implanted dopants to form the emitter region and collector region;

removing said silicon nitride layer atop said base electrode to expose said polycrystalline silicon layer;

implanting dopants of first conductivity type into said polycrystalline silicon layer of said base electrode; and

-39-

diffusing said dopants implanted into said polycrystalline silicon layer to reach the boundary plane to said insulating layer of said substrate.

Fig. 1

E    B    C

n⁺    n⁺

P

S

Prior Art

Fig. 2

(a)

E    B    C

n    p    n    We

I

Wb

Prior Art

(b)

E    B    C

He    Hc

I

Hb

Prior Art

Fig.3

Fig. 4

(a)

12 17 15 1314 18

19

(b)

12 17 15 17 18
$P^+$

$We$

$n^+$ P $n$ $n^+$ 19

16

17s } 11

$W_b$

13 14

Fig. 5

(a)

N

base electrode    base region    $SiO_2$

(b)

E

base
electrode    base
region    $SiO_2$

(c)

N

base
electrode    base region    $SiO_2$

N: dopant density

E: electric field intensity

4/9   Fig. 6

(a)

(b)

(c)

(d)

5/9 Fig. 6

(e)

30E
25B
27
29
26 } 21
20

(f)

27E 30B
25B 27B
29
W W
26 } 21
20

(g)

B⁺ 27B 30B
27B 24n 32
25B
29
26 } 21
20
B⁺

(h)

27B 30B
23 27B 24n
25B
29
P n
26 } 21
20

Fig. 6

0137992

6/9

Fig. 7  7/9

0137992

(a), (b), (c), (d)

8/9  Fig. 8

(a)

B⁺ → B⁺ ··· 43 ··· 49 ··· 46 } 41 ··· 40

(b)

47B 45B 50B 47B ··· P⁺ ··· 49 ··· 46 } 41 ··· 40

(c)

42 47B 45B 50B 47B 44 ··· n P n ··· 49 ··· 46 } 41 ··· 40

(d)

42 47B 45B 47B 44 ··· B⁺ ··· n P n ··· 49 ··· 46 } 41 ··· 40 ··· B⁺

Fig. 9

Fig. 10